# EUROPEAN PATENT APPLICATION

(11) **EP 4 080 596 A1**
(43) Date of publication of application: **26.10.2022**
(21) Application number: 20903358.8
(22) Date of filing: 14.12.2020
(51) Int. Cl.: H01L 51/44

(54) **LIGHT ABSORPTION LAYER, METHOD FOR PRODUCING SAME, COATING LIQUID, PHOTOELECTRIC CONVERSION ELEMENT, AND INTERMEDIATE BAND SOLAR CELL**

(30) Priority: 18.12.2019 WO PCT/JP2019/049578
(71) Applicant: Kao Corporation, Chuo-ku Tokyo 103-8210 (JP)
(72) Inventor: OGOMI,Yuhei, Wakayama-shi, Wakayama 640-8580 (JP); SAWADA,Takuya, Wakayama-shi, Wakayama 640-8580 (JP); OKONOGI,Akinori, Wakayama-shi, Wakayama 640-8580 (JP); FURUSAWA,Kosuke, Wakayama-shi, Wakayama 640-8580 (JP)
(74) Representative: Hoffmann Eitle
(86) International application number: PCT/JP2020/046449
(87) International publication number: WO 2021/125120

(57) **Abstract**

The present invention relates to a light absorption layer for forming a photoelectric conversion element and an intermediate band solar cell excellent in quantum yield of two-step photon absorption, a photoelectric conversion element, and an intermediate band solar cell having the light absorption layer, the light absorption layer of the present invention containing a perovskite compound and a quantum dot having an upper end of a valence band at an energy level more negative than an upper end of a valence band of the perovskite compound, and having an intermediate band.

## Description

### TECHNICAL FIELD

The present invention relates to a light absorption layer and a method for producing the light absorption layer, a coating liquid for producing the light absorption layer, a photoelectric conversion element having the light absorption layer, and an intermediate band solar cell having the photoelectric conversion element.

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since a single-junction solar cell represented by a silicon solar cell has a single band gap, the single-junction solar cell cannot exceed the photoelectric conversion efficiency of the Shockley-Queisser theoretical limit (31%) (Journal of Applied Physics, 32, 510 (1961)). As a means to exceed this theoretical limit, an intermediate-band solar cell has been proposed (Physical Review Letters, 78, 5014 (1997)). By regularly arranging nano-sized semiconductors (quantum dots) in a bulk (matrix) semiconductor at high density, an "intermediate-band" due to quantum dot interaction is formed within the band gap of the bulk semiconductor. As a result, photoexcitation from the valence band of the bulk semiconductor to the "intermediate-band" and photoexcitation from the "intermediate-band" to the conduction band of the bulk semiconductor (two-step light absorption) become possible in addition to photoexcitation from the valence band to the conduction band of the bulk semiconductor, thereby to be able to use multiple solar energies. Thus, the photoelectric conversion efficiency is expected to be improved. However, since the intermediate-band solar cell is manufactured by a dry process such as a molecular beam epitaxy (MBE) method, such a solar cell is expensive and elements that can be used are limited to GaAs (band gap energy 1.4 eV) etc. Therefore, it is difficult to optimize the band structure and there is a limit in improving the photoelectric conversion efficiency.

On the other hand, a method for producing a quantum dot solar cell by a wet process has been proposed. For example, JP-A-2014-135445 proposes a method for producing a semiconductor device including a photoelectric conversion layer having a quantum dot structure having a PN junction, the method including: spraying any one or both of first conductivity type semiconductor particles and second conductivity type semiconductor particles on a substrate to form the photoelectric conversion layer when forming, on the substrate, any one of a photoelectric conversion layer in which a first conductivity type semiconductor layer made of the first conductivity type semiconductor particles and a second conductivity type semiconductor layer made of the second conductivity type semiconductor particles different from the first conductivity type semiconductor particles are sequentially laminated, or a photoelectric conversion layer in which the second conductivity type semiconductor particles different from the first conductivity type semiconductor particles are dispersed in the first conductivity type semiconductor layer made of the first conductivity type semiconductor particles.

In addition, a method for producing an intermediate band solar cell produced by a wet process has been proposed. For example, JP-B-6343406 proposes a method for producing a light absorption layer containing quantum dots dispersed in a matrix of a bulk semiconductor, and having an intermediate band, the method including following steps 1, 2, and 3:
(step 1) a step of exchanging an organic ligand of a quantum dot containing the organic ligand with a halogen element-containing substance to obtain a quantum dot solid containing the halogen element-containing substance as a ligand;
(step 2) a step of mixing the quantum dot solid obtained in step 1 with a solution or a mixed liquid containing one or more kinds of substances selected from a bulk semiconductor and a precursor thereof to obtain a dispersion; and
(step 3) a step of obtaining a light absorption layer from the dispersion obtained in step 2.

In order to improve the photoelectric conversion efficiency of the intermediate band solar cell, it is necessary to prolong the lifetime of the carriers in the intermediate band. When the lifetime of the carriers in the intermediate band is prolonged, energy loss due to carrier recombination is suppressed, so that the photoelectric conversion efficiency can be improved.

JP-A-2006-114815 proposes a solar cell that has a pin structure and includes a quantum dot satisfying a specific condition and having a three-dimensional quantum confinement effect in an i-layer as a light detection layer, wherein the energy band structures of the quantum dot and the barrier layer enclosing the quantum dot are type II. In the i-layer, the energy band structures of the quantum dot and the barrier layer enclosing the quantum dot are type II, and thus holes generated through light absorption easily move to the outside of the quantum dot. As a result, it is considered that recombination between holes and photoexcited electrons is suppressed, and the lifetime of carriers is prolonged, thus improving the carrier extraction efficiency.

However, the i-layer of JP-A-2006-114815 is produced by a molecular beam epitaxy (MBE) method, which requires expensive cost, and usable quantum dots and base materials (materials of the barrier layer) are limited. Therefore, optimization of the band structure is difficult, and improvement of photoelectric conversion efficiency is limited.

In addition, JP-B-6343406 does not disclose a method for prolonging the lifetime of the carriers in the intermediate band or the relationship between the valence band of the bulk semiconductor and the valence band of the quantum dot.

There is a perovskite solar cell as the most promising candidate for the next generation solar cell, which has been recently reported to show a rapid increase in photoelectric conversion efficiency. This perovskite solar cell is provided with a photoelectric conversion element using a perovskite compound (CH₃NH₃PbI₃) composed of a cation (such as methyl ammonium) and a halogenated metal salt (such as lead iodide) for the light absorption layer (J. Am. Chem. Soc. 2009, 131, 6050-6051). The perovskite solar cell can attain photoelectric conversion in a visible light region (400 to 800 nm) and shows a relatively high conversion efficiency. However, the perovskite solar cell cannot utilize a near-infrared light region to be insufficient in effective utilization of sunlight.

In recent years, A quantum dot solar cell has been reported which make use of PbS quantum dots surface-treated with a perovskite compound (CH₃NH₃PbI₃) in a light absorption layer (Nano Lett. 2015, 15, 7539-7543). However, the perovskite compound is small in quantity so that the compound hardly contributes to power generation. Thus, the solar cell is insufficient in conversion efficiency.

### SUMMARY OF THE INVENTION

The present invention relates to a light absorption layer for forming a photoelectric conversion element and an intermediate-band solar cell excellent in quantum efficiency of two-step light absorption, a photoelectric conversion element having the light absorption layer, and an intermediate-band solar cell having the light absorption layer.

The present inventors have found that the quantum yield of two-step photon absorption of the photoelectric conversion element is improved by using a light absorption layer having an intermediate band, which is obtained by dispersing quantum dots having an upper end of a valence band at an energy level more negative than an upper end of a valence band of the perovskite compound in a matrix of the perovskite compound at a higher density.

That is, the present invention relates to a light absorption layer containing: a perovskite compound; and a quantum dot having an upper end of a valence band at an energy level more negative than an upper end of a valence band of the perovskite compound, the light absorption layer having an intermediate band.

The present invention also relates to a coating liquid containing: a perovskite compound or a precursor thereof; and a quantum dot having an upper end of a valence band at an energy level more negative than an upper end of a valence band of the perovskite compound.

Further, the present invention relates to a method for producing a light absorption layer containing: a perovskite compound; and a quantum dot having an upper end of a valence band at an energy level more negative than an upper end of a valence band of the perovskite compound dispersed in a matrix of the perovskite compound, and having an intermediate band, the method including following steps 1 and 2:
(step 1) a step of mixing the quantum dot or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

The use of the perovskite compound and the quantum dot as a material for forming the light absorption layer enables absorption of light in a wide wavelength region including not only light in a short wavelength region, which can be absorbed by the perovskite compound, but also light in a long wavelength region such as a near-infrared light region, which can be absorbed by the quantum dot. Thus, a photoelectric conversion element having a photoelectric conversion function in a wide wavelength region can be obtained. In addition, the quantum dots, which are dispersed in the matrix of the perovskite compound at a high density, interact with each other to form an intermediate band in the band gap of the perovskite compound. This allows two-step photon absorption of, for example, photoexcitation from the valence band of the perovskite compound to the intermediate band and photoexcitation from the intermediate band to the conduction band of the perovskite compound, and thus improves the photoelectric conversion efficiency.

In addition, the use of the quantum dot having an upper end of a valence band at an energy level more negative than an upper end of a valence band of the perovskite compound improves the diffusibility of holes generated through light absorption (holes easily move to the outside of the quantum dot). As a result, recombination between holes and electrons photoexcited to the intermediate band is suppressed, and the lifetime of the carriers is prolonged, thus improving the carrier extraction efficiency. Consequently, it is considered that the quantum yield of two-step photon absorption is improved.

Therefore, the use of the light absorption layer of the present invention enables obtaining a photoelectric conversion element and an intermediate band solar cell excellent in quantum yield of two-step photon absorption.

The present invention also relates to a light absorption layer for forming a photoelectric conversion element and an intermediate band solar cell which enable photoelectric conversion in both a visible light region and a near-infrared light region, and which have a high conversion efficiency and an excellent quantum yield of two-step photon absorption, a photoelectric conversion element, and an intermediate band solar cell having the light absorption layer.

The present inventors have found that the photoelectric conversion efficiency is improved by using a light absorption layer containing a perovskite compound and a quantum dot made of an indirect transition type semiconductor, and having an intermediate band.

That is, the present invention relates to a light absorption layer containing: a perovskite compound; and a quantum dot made of an indirect transition type semiconductor, the light absorption layer having an intermediate band.

The present invention also relates to a coating liquid containing: a perovskite compound or a precursor thereof; and a quantum dot made of an indirect transition type semiconductor.

Further, the present invention relates to a method for producing a light absorption layer containing: a perovskite compound; and a quantum dot made of an indirect transition type semiconductor dispersed in a matrix of the perovskite compound, and having an intermediate band, the method including following steps 1 and 2:
(step 1) a step of mixing the quantum dot made of an indirect transition type semiconductor or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

The use of the perovskite compound and the quantum dot made of an indirect transition type semiconductor as a material for forming the light absorption layer enables absorption of light in a wide wavelength region including not only light in a short wavelength region, which can be absorbed by the perovskite compound, but also light in a long wavelength region such as a near-infrared light region, which can be absorbed by the quantum dot. Thus, a photoelectric conversion element having a photoelectric conversion function in a wide wavelength region can be obtained. In addition, the quantum dots, which are dispersed in the matrix of the perovskite compound at a high density, interact with each other to form an intermediate band in the band gap of the perovskite compound. This allows two-step photon absorption of, for example, photoexcitation from the valence band of the perovskite compound to the intermediate band and photoexcitation from the intermediate band to the conduction band of the perovskite compound, and thus improves the photoelectric conversion efficiency.

Also, the use of the quantum dot made of an indirect transition type semiconductor suppresses recombination of carriers generated through light absorption. This prolongs the lifetime of the carriers and thus improves the carrier extraction efficiency. Therefore, the light absorption layer (composite film) of the present invention containing a perovskite compound and a quantum dot made of an indirect transition type semiconductor is superior in photoelectric conversion efficiency to the conventional light absorption layer using a quantum dot made of a direct transition type semiconductor.

Therefore, the use of the light absorption layer of the present invention enables obtaining a photoelectric conversion element and an intermediate band solar cell which enable photoelectric conversion in both a visible light region and a near-infrared light region, and which have a high conversion efficiency and an excellent quantum yield of two-step photon absorption.

### BRIEF DESCRIPTION OF THE DRAWINGS

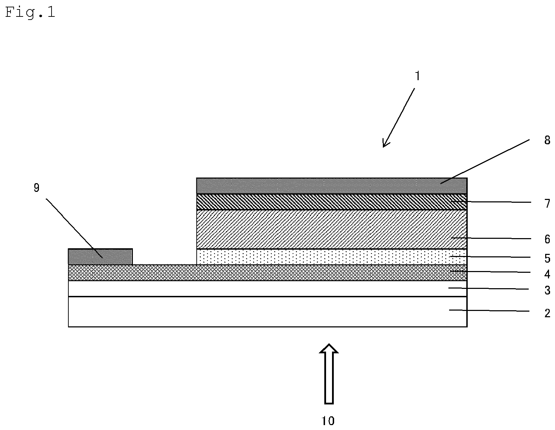

Fig. 1 is a schematic cross-sectional view showing an example of the structure of a photoelectric conversion element of the present invention.

### MODE FOR CARRYING OUT THE INVENTION

### <Light Absorption Layer>

A light absorption layer A of the present invention contains, as a light absorber, a perovskite compound and a quantum dot having an upper end of a valence band at an energy level more negative than an upper end of a valence band of the perovskite compound. The light absorption layer A of the present invention may contain a light absorber other than the above substances as long as the effect of the present invention is not impaired.

A light absorption layer B of the present invention contains, as a light absorber, a perovskite compound and a quantum dot made of an indirect transition type semiconductor. The light absorption layer B of the present invention may contain a light absorber other than the above substances as long as the effect of the present invention is not impaired.

The light absorption layer A and the light absorption layer B of the present invention has an intermediate-band. The intermediate-band is an energy level formed within the band gap of the perovskite compound by the interaction between quantum dots and exists at the energy position near the lower end of the conduction band of the quantum dot and/or near the upper end of the valence band of the quantum dot. The intermediate-band is formed, for example, by regularly arranging quantum dots at high density in a bulk semiconductor matrix. If an intermediate-band is present within the band gap of the perovskite compound, for example, two-step light absorption occurs in such a manner that electrons photoexcited from a valence band of the perovskite compound to an intermediate-band further photoexcite from the intermediate-band to a conduction band of the perovskite compound. Therefore, the presence of the intermediate-band can be confirmed by measuring the quantum efficiency of two-step light absorption, that is, the external quantum efficiency difference described.

The energy difference between the valence band of the perovskite compound and the intermediate band is preferably 1.1 eV or more, more preferably 1.2 eV or more, still more preferably 1.3 eV or more, still more preferably 1.4 eV or more, and preferably 2.0 eV or less, more preferably 1.8 eV or less, still more preferably 1.6 eV or less, from the viewpoint of improving the photoelectric conversion efficiency.

The energy difference between the intermediate band and the conduction band of the perovskite compound is preferably 0.5 eV or more, more preferably 0.6 eV or more, still more preferably 0.7 eV or more, and preferably 2.0 eV or less, more preferably 1.5 eV or less, still more preferably 1.0 eV or less, still more preferably 0.9 eV or less, from the viewpoint of improving the photoelectric conversion efficiency.

The perovskite compound is not particularly limited, and is preferably one or more kinds selected from a compound represented by the following general formula (1) and a compound represented by the following general formula (2), more preferably a compound represented by the following general formula (1) from the viewpoint of improving the photoelectric conversion efficiency.

RMX₃ (1)

(R is a monovalent cation, M is a divalent metal cation, and X is a halogen anion.)

R¹R²R³ₙ₋₁MₙX₃ₙ₊₁ (2)

(R¹, R² and R³ are each independently a monovalent cation, M is a divalent metal cation, X is a halogen anion, and n is an integer of 1 to 10.)

The R is a monovalent cation, for example, a cation of the group 1 of the periodic table and includes an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of improving durability and photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of R¹, R², and R³ mentioned above is independently a monovalent cation, and any or all of R¹, R², and R³ may be the same. For example, examples of the monovalent cation include a cation of the group 1 of the periodic table and an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of improving durability and photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of improving durability and photoelectric conversion efficiency, n is preferably 1 to 4.

The M is a divalent metal cation and includes, for example, Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺. From the viewpoint of excellent durability (moisture resistance) and photoelectric conversion efficiency, the M is preferably Pb²⁺, Sn²⁺, or Ge²⁺, more preferably Pb²⁺ or Sn²⁺, still more preferably Pb²⁺.

The X is a halogen anion, and examples thereof include a fluorine anion, a chlorine anion, a bromine anion, and an iodine anion. In order to obtain a perovskite compound having a desired band gap energy, the X is preferably a fluorine anion, a chlorine anion or a bromine anion, more preferably a chlorine anion or a bromine anion, still more preferably a bromine anion.

The perovskite compound is not particularly limited as far as the compound is a compound having a perovskite type crystal structure. From the viewpoint of improving the photoelectric conversion efficiency, preferred is a perovskite compound having a band gap energy of 1.5 eV or more and 4.0 eV or less. The perovskite compound may be used alone, or two or more perovskite compounds different in band gap energy may be used.

From the viewpoint of improving the photoelectric conversion efficiency (voltage), the band gap energy of the perovskite compound is more preferably 1.7 eV or more, still more preferably 2.0 eV or more, even still more preferably 2.1 eV or more, even still more preferably 2.2 eV or more, and from the viewpoint of improving the photoelectric conversion efficiency (current), the band gap energy of the perovskite compound is more preferably 3.6 eV or less, still more preferably 3.0 eV or less, even still more preferably 2.4 eV or less. The band gap energies of the perovskite compound and the quantum dot can be determined from the absorption spectrum measured at 25°C by the method described in Examples described later. The wavelength corresponding to the band gap energy determined from the absorption spectrum is called an absorption edge wavelength.

Examples of the compound represented by the general formula (1) having a band gap energy of 1.5 eV or more and 4.0 eV or less include CH₃NH₃PbCl₃, CH₃NH₃PbBr₃, CH₃NH₃PbI₃, CH₃NH₃PbBrI₂, CH₃NH₃PbBr₂I, CH₃NH₃SnCl₃, CH₃NH₃SnBr₃, CH₃NH₃SnI₃, CH(=NH)NH₃PbCl₃, and CH(=NH)NH₃PbBr₃. Among these, from the viewpoint of improving durability and photoelectric conversion efficiency, CH₃NH₃PbBr₃ and CH(=NH)NH₃PbBr₃ are preferable and CH₃NH₃PbBr₃ is more preferable.

Examples of the compound represented by the general formula (2) having a band gap energy of 1.5 eV or more and 4.0 eV or less include (C₄H₉NH₃) ₂PbI₄, (C₆H₁₃NH₃) ₂PbI₄, (C₈H₁₇NH₃) ₂PbI₄, (C₁₀H₂₁NH₃) ₂PbI₄, (C₁₂H₂₅NH₃) ₂PbI₄, (C₄H₉NH₃)₂(CH₃NH₃)Pb₂I₇, (C₆H₁₃NH₃)₂(CH₃NH₃)Pb₂I₇, (C₈H₁₇NH₃)₂(CH₃NH₃)Pb₂I₇, (C₁₀H₂₁NH₃)₂(CH₃NH₃)Pb₂I₇, (C₁₂H₂₅NH₃)₂(CH₃NH₃)Pb₂I₇, (C₄H₉NH₃)₂(CH₃NH₃)₂Pb₃I₁₀, (C₆H₁₃NH₃)₂(CH₃NH₃)₂Pb₃I₁₀, (C₈H₁₇NH₃)₂(CH₃NH₃)₂Pb₃I₁₀, (C₁₀H₂₁NH₃)₂(CH₃NH₃)₂Pb₃I₁₀, (C₁₂H₂₅NH₃)₂(CH₃NH₃)₂Pb₃I₁₀, (C₄H₉NH₃) ₂PbBr₄, (C₆H₁₃NH₃)₂PbBr₄, (C₈H₁₇NH₃) ₂PbBr₄, (C₁₀H₂₁NH₃) ₂PbBr₄, (C₄H₉NH₃)₂(CH₃NH₃) Pb₂Br₇, (C₆H₁₃NH₃)₂(CH₃NH₃) Pb₂Br₇, (C₈H₁₇NH₃)₂(CH₃NH₃) Pb₂Br₇, (C₁₀H₂₁NH₃)₂(CH₃NH₃)Pb₂Br₇, (C₁₂H₂₅NH₃)₂(CH₃NH₃) Pb₂Br₇, (C₄H₉NH₃)₂(CH₃NH₃)₂Pb₃Br₁₀, (C₆H₁₃NH₃)₂(CH₃NH₃)₂Pb₃Br₁₀, (C₈H₁₇NH₃)₂(CH₃NH₃)₂Pb₃Br₁₀, (C₁₀H₂₁NH₃)₂(CH₃NH₃)₂Pb₃Br₁₀, (C₁₂H₂₅NH₃)₂(CH₃NH₃)₂Pb₃Br₁₀, (C₄H₉NH₃)₂(CH₃NH₃)₂Pb₃Cl₁₀, (C₆H₁₃NH₃)₂(CH₃NH₃)₂Pb₃Cl₁₀, (C₈H₁₇NH₃)₂(CH₃NH₃)₂Pb₃Cl₁₀, (C₁₀H₂₁NH₃)₂(CH₃NH₃)₂Pb₃Cl₁₀, and (C₁₂H₂₅NH₃)₂(CH₃NH₃)₂Pb₃Cl₁₀.

The perovskite compound can be produced, for example, from a perovskite compound precursor as described later. As a precursor of the perovskite compound, for example, in the case where the perovskite compound is a compound represented by the general formula (1), a combination of a compound represented by MX₂ and a compound represented by RX can be mentioned. Also, in the case where the perovskite compound is a compound represented by the general formula (2), a combination of a compound represented by MX₂ with one or more kinds selected from a compound represented by R¹X, a compound represented by R²X, and a compound represented by R³X can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The energy level at the upper end of the valence band of the quantum dot varies depending on the size of the particle size (ACS Appl. Mater. Interfaces 2015, 7, 17482-17488). In the present invention, the particle size of the quantum dot is preferably 0.1 nm or more, more preferably 1 nm or more, still more preferably 2 nm or more, and preferably 10 nm or less, more preferably 5 nm or less, still more preferably 3 nm or less, from the viewpoint that the upper end of the valence band of the quantum dot holds an energy level more negative than the upper end of the valence band of the perovskite compound, and from the viewpoint of improving dispersibility, structural stability, and photoelectric conversion efficiency. The particle size of the quantum dot can be measured by an ordinary method such as crystallite diameter analysis of X-ray diffraction (XRD) or transmission electron microscope observation.

Regarding the quantum dots, if the particle size and kind of quantum dots are determined by electron microscopic observation, electron beam diffraction, X-ray diffraction pattern, etc., it is also possible to calculate the band gap energy from the correlation between the particle size and the band gap energy (see, for example, ACS Nano 2018, 12, 8350-8361,and ACS Nano 2014, 8, 6363-6371).

The quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

Examples of the quantum dot having an upper end of a valence band at an energy level more negative than an upper end of a valence band of the perovskite compound include quantum dots containing one or more kinds of elements selected from the group consisting of Si, Cu, Ge, Ag, Ga, and Al, and specific examples thereof include Si, CuInS₂, and Ag₈SnS₆. From the viewpoint of power generation efficiency, the quantum dot is preferably at least one kind selected from the group consisting of Si, CuInS₂, and Ag₈SnS₆, and more preferably Si or CuInS₂.

Examples of the quantum dot made of an indirect transition type semiconductor include quantum dots containing one or more kinds of elements selected from the group consisting of Si, Cu, C, Ge, Ag, Ga, and Al, and specific examples thereof include Si, SiC, Ge, AlSb, AlAs, AlP, AlGaAs, GaP, CuIn, AgZnS, and Ag₈SnS₆. From the viewpoint of power generation efficiency, the quantum dot is preferably at least one kind selected from the group consisting of Si and Ag₈SnS₆, and more preferably Si.

The quantum dot having an upper end of a valence band at an energy level more negative than an upper end of a valence band of the perovskite compound is preferably a quantum dot made of the indirect transition type semiconductor from the viewpoint of power generation efficiency, and specific examples thereof include Si and Ag₈SnS₆.

The band gap energy of the quantum dot is not particularly limited, but is preferably 0.5 eV or more and equal to or less than the band gap energy of the perovskite compound, from the viewpoint of complementing the band gap energy which the perovskite compound does not have to improve photoelectric conversion efficiency in the near-infrared light region. The quantum dot may be used singly or in combination of two or more types having different band gap energies. When two or more types of perovskite compounds having different band gap energies are used, the "band gap energy equal to or less than the band gap energy of the perovskite compound" which is the upper limit of the band gap energy of the quantum dot is the band gap energy equal to or less than the maximum value of the band gap energies of the two or more types of perovskite compounds. As described above, the band gap energy of the quantum dot can be obtained from the absorption spectrum measured at 25°C by the method described in Examples described later.

The band gap energy of the quantum dot is preferably 0.7 eV or more, more preferably 0.8 eV or more, and still more preferably 0.9 eV or more, from the viewpoint of improving the photoelectric conversion efficiency (voltage). The band gap energy of the quantum dot is preferably 1.6 eV or less, more preferably 1.5 eV or less, still more preferably 1.4 eV or less, and still more preferably 1.3 eV or less, from the viewpoint of improving the photoelectric conversion efficiency (current).

The difference between the band gap energy of the perovskite compound and the band gap energy of the quantum dot is preferably 0.4 eV or more, more preferably 0.6 eV or more, still more preferably 0.7 eV or more, still more preferably 0.8 eV or more, and preferably 2.0 eV or less, more preferably 1.5 eV or less, still more preferably 1.3 eV or less, still more preferably 1.0 eV or less, from the viewpoint of improving the photoelectric conversion efficiency.

The absolute value of the energy level difference between the upper end of the valence band of the perovskite compound and the upper end of the valence band of the quantum dot is preferably 0.01 eV or more, more preferably 0.02 eV or more, still more preferably 0.03 eV or more, and preferably 1.0 eV or less, more preferably 0.5 eV or less, still more preferably 0.3 eV or less, from the viewpoint of improving the diffusibility of holes generated through light absorption.

A preferable combination of the perovskite compound and the quantum dot is, for example, CH₃NH₃PbBr₃ and Si or CuInS₂, CH₃NH₃PbI₃ and Si or CuInS₂, CH(=NH)NH₃PbBr₃ and Si or CuInS₂, or the like, and is preferably a combination of CH₃NH₃PbBr₃ and Si or CuInS₂, from the viewpoint of uniform dispersibility of the quantum dot, durability of the light absorption layer, and photoelectric conversion efficiency.

The content of the quantum dot in the light absorption layer is preferably 3% by volume or more, more preferably 4% by volume or more, and still more preferably 5% by volume or more, from the viewpoint of filling the quantum dots at a high density to reduce the distance between the quantum dots and allowing the quantum dots to interact with each other to form an intermediate band in the light absorption layer, thus improving the quantum yield of two-step photon absorption. The content is preferably 40% by volume or less, more preferably 30% by volume or less, and still more preferably 25% by volume or less, from the viewpoint of film-forming property, and suppressing carrier transfer from the perovskite compound to the quantum dot to improve the photoelectric conversion efficiency.

The thickness of the light absorption layer is not particularly limited, but is preferably 30 nm or more, more preferably 50 nm or more, still more preferably 80 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the viewpoint of improving photoelectric conversion efficiency by improving carrier transfer efficiency to a hole transport material layer and an electron transport material layer. The thickness of the light absorption layer can be measured by a measuring method such as electron microscope observation of the cross section of the film.

### <Method for manufacturing light absorption layer>

The method for manufacturing the light absorption layer A is not particularly limited. For example, a so-called wet process in which a coating liquid containing a perovskite compound and/or a precursor thereof and the quantum dot is coated on a substrate and then dried is preferably mentioned. From the viewpoints of ease of production, cost, storage stability of the coating liquid, improvement of photoelectric conversion efficiency, etc., a manufacturing method including the following step 1, and step 2 is preferable.
(step 1) a step of mixing the quantum dot or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

The method for producing the light absorption layer B is not particularly limited, and preferable examples thereof include a method based on a so-called wet process in which a coating liquid containing a perovskite compound and/or a precursor thereof and a quantum dot made of an indirect transition type semiconductor is applied onto a substrate and dried. From the viewpoint of ease of production, cost, storage stability of the coating liquid, improvement of photoelectric conversion efficiency, and the like, a production method including following steps 1 and 2 is preferable:
(step 1) a step of mixing the quantum dot made of an indirect transition type semiconductor or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

Examples of the solvent of the dispersion, the solution, and the mixed liquid include esters (methyl formate, ethyl formate, and the like), ketones (γ-butyrolactone, N-methyl-2-pyrrolidone, acetone, dimethyl ketone, diisobutyl ketone, and the like), ethers (diethyl ether, methyl-tert-butyl ether, dimethoxymethane, 1,4-dioxane, tetrahydrofuran, and the like), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, and the like), glycol ethers (cellosolve), amide-based solvents (N,N-dimethylformamide, acetamide, N,N-dimethylacetamide, and the like), nitrile-based solvents (acetonitrile, isobutyronitrile, propionitrile, methoxyacetonitrile, and the like), carbonate-based solvents (ethylene carbonate, propylene carbonate, and the like), halogenated hydrocarbons (methylene chloride, dichloromethane, chloroform, and the like), hydrocarbons, and dimethyl sulfoxide.

The solvent is preferably a polar solvent, more preferably at least one kind of solvent selected from ketones, amide-based solvents, and dimethyl sulfoxide, still more preferably an amide-based solvent, and still more preferably N,N-dimethylformamide, from the viewpoint of film-forming property, cost, storage stability, and expression of excellent performance (for example, photoelectric conversion property).

The metal concentration of the perovskite compound and/or the precursor thereof in the coating liquid is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less, from the viewpoint of film-forming property, cost, storage stability, and expression of excellent performance (for example, photoelectric conversion property).

The concentration of the quantum dot in the coating liquid is preferably 10 mg/mL or more, more preferably 15 mg/mL or more, still more preferably 20 mg/mL or more, and preferably 300 mg/mL or less, more preferably 100 mg/mL or less, still more preferably 50 mg/mL or less, from the viewpoint of film-forming property, cost, storage stability, and expression of excellent performance (for example, photoelectric conversion property).

The method for preparing the coating liquid is not particularly limited, but the mixing temperature is preferably 0°C or higher, more preferably 10°C or higher, still more preferably 20°C or higher, and preferably 50°C or lower, more preferably 40°C or lower, still more preferably 30°C or lower, from the viewpoint of ease of production, cost, storage stability, improvement of photoelectric conversion efficiency, and the like. From the same viewpoint, the mixing time is preferably more than 0 hours, more preferably 0.1 hours or more, and preferably 72 hours or less, more preferably 24 hours or less, still more preferably 1 hour or less.

The coating liquid is preferably filtered to remove coarse particles. The pore size of the filter at the time of filtration is preferably 0.1 µm or more, more preferably 0.2 µm or more, and preferably 1 µm or less, more preferably 0.5 µm or less, from the viewpoint of ease of production, cost, storage stability, improvement of photoelectric conversion efficiency, and the like. The material of the filter is preferably hydrophobic, more preferably polytetrafluoroethylene (PTFE).

The step (step 2) of obtaining a light absorption layer from the coating liquid obtained in step 1 is preferably a wet process such as applying (coating) the coating liquid obtained in step 1 onto a substrate (functional layer). Examples of the wet process include a gravure coating method, a bar coating method, a printing method, a spraying method, a spin coating method, a dipping method, and a die coating method. A spin coating method is preferable from the viewpoint of ease of production, cost, and expression of excellent performance (for example, photoelectric conversion property). The maximum rotation speed of the spin coater in the spin coating method is preferably 500 rpm or more, more preferably 1,000 rpm or more, still more preferably 2,000 rpm or more, and preferably 8,000 rpm or less, more preferably 7,000 rpm or less, still more preferably 6,000 rpm or less, from the viewpoint of exhibiting excellent performance (for example, photoelectric conversion property).

In addition, from the viewpoint of ease of production, cost, improvement of photoelectric conversion property, and the like, the crystal deposition rate of the perovskite compound may be improved by applying or dropping a poor solvent of a perovskite compound after applying the coating liquid onto the substrate (functional layer). The poor solvent is preferably toluene, chlorobenzene, dichloromethane, or a mixed solvent thereof.

Examples of the drying method in the wet process include thermal drying, air flow drying, vacuum drying, and the like, and thermal drying is preferable from the viewpoint of ease of production, cost, expression of excellent performance (for example, photoelectric conversion property), and the like. The temperature of thermal drying is preferably 60°C or higher, more preferably 80°C or higher, and still more preferably 90°C or higher, from the viewpoint of exhibiting excellent performance (for example, photoelectric conversion property). The temperature of thermal drying is preferably 200°C or lower, more preferably 150°C or lower, still more preferably 120°C or lower, and still more preferably 110°C or lower from the same viewpoint and cost. The time for thermal drying is preferably 1 minute or more, more preferably 5 minutes or more, and still more preferably 8 minutes or more, from the viewpoint of exhibiting excellent performance (for example, photoelectric conversion property). The time for thermal drying is preferably 120 minutes or less, more preferably 60 minutes or less, still more preferably 20 minutes or less, and still more preferably 12 minutes or less from the same viewpoint and cost.

### <Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

Hereinafter, the configuration and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide (SnO₂), indium zinc oxide (IZO), zinc oxide (ZnO), a polymer material having high conductivity and the like can be mentioned. Examples of the polymer material include polyacetylene-based polymer materials, polypyrrole-based polymer materials, polythiophene-based polymer materials, and polyphenylenevinylene-based polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a coating liquid containing a perovskite compound and/or a precursor thereof and the quantum dots is prepared and the prepared coating liquid is coated on the surface of the porous layer 5, and is dried. From the viewpoints of ease of production, cost, storage stability of the coating liquid, improvement of photoelectric conversion efficiency and the like, a manufacturing method including step 1, and step 2 is preferable as a method of forming the light absorption layer 6.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

### <Intermediate-Band Solar Cell>

The intermediate-band solar cell of the present invention has the photoelectric conversion element. In the intermediate-band solar cell of the present invention, the configuration other than the light absorption layer is not particularly limited, and a known solar cell configuration can be applied.

The present invention and preferred embodiments of the present invention are described below.
<1>
   A light absorption layer comprising: a perovskite compound; and a quantum dot having an upper end of a valence band at an energy level more negative than an upper end of a valence band of the perovskite compound, the light absorption layer having an intermediate band.
<2>
   The light absorption layer according to <1>, wherein the quantum dot is an indirect transition type semiconductor.
<3>
   A light absorption layer comprising: a perovskite compound; and a quantum dot made of an indirect transition type semiconductor, the light absorption layer having an intermediate band.
<4>
   The light absorption layer according to any one of <1> to <3>, wherein an energy difference between a valence band of the perovskite compound and the intermediate-band is preferably 1.1 eV or more, more preferably 1.2 eV or more, still more preferably 1.3 eV or more, and preferably 2.0 eV or less, more preferably 1.8 eV or less, still more preferably 1.6 eV or less.
<5>
   The light absorption layer according to any one of <1> to <4>, wherein an energy difference between the intermediate-band and a conduction band of the perovskite compound is preferably 0.5 eV or more, more preferably 0.6 eV or more, still more preferably 0.7 eV or more, and preferably 2.0 eV or less, more preferably 1.5 eV or less, still more preferably 1.0 eV or less.
<6>
   The light absorption layer according to any one of <1> to <3>, wherein preferably, the energy difference between the valence band of the perovskite compound and the intermediate band is 1.1 eV or more and 2.0 eV or less, and the energy difference between the intermediate band and the conduction band of the perovskite compound is 0.5 eV or more and 2.0 eV or less,
   more preferably, the energy difference between the valence band of the perovskite compound and the intermediate band is 1.2 eV or more and 1.8 eV or less, and the energy difference between the intermediate band and the conduction band of the perovskite compound is 0.6 eV or more and 1.5 eV or less,
   still more preferably, the energy difference between the valence band of the perovskite compound and the intermediate band is 1.3 eV or more and 1.6 eV or less, and the energy difference between the intermediate band and the conduction band of the perovskite compound is 0.7 eV or more and 1.0 eV or less, and
   still more preferably, the energy difference between the valence band of the perovskite compound and the intermediate band is 1.4 eV or more and 1.6 eV or less, and the energy difference between the intermediate band and the conduction band of the perovskite compound is 0.7 eV or more and 0.9 eV or less.
<7>
   The light absorption layer according to any one of <1> to <6>, wherein the perovskite compound is preferably one or more kinds selected from a compound represented by the following general formula (1) and a compound represented by the following general formula (2), more preferably a compound represented by the following general formula (1).

   RMX₃ (1)

   wherein R is a monovalent cation, M is a divalent metal cation, and X is a halogen anion, and

   R¹R²R³ₙ₋₁MₙX₃ₙ₊₁ (2)

   wherein R¹, R², and R³ are each independently a monovalent cation, M is a divalent metal cation, X is a halogen anion, and n is an integer of 1 or more and 10 or less.
<8>
   The light absorption layer according to <7>, wherein the R is one or more kinds selected from a cation of the group 1 of the periodic table and an organic cation, the cation of the group 1 of the periodic table is preferably one or more kinds selected from Li⁺, Na⁺, K⁺ and Cs⁺, the organic cation is preferably one or more kinds selected from an ammonium ion which may have a substituent and a phosphonium ion which may have a substituent, the ammonium ion which may have a substituent is preferably one or more kinds selected from an alkylammonium ion, a formamidinium ion and an arylammonium ion, more preferably one or more kinds selected from an alkylammonium ion and a formamidinium ion, still more preferably one or more kinds selected from a monoalkylammonium ion and a formamidinium ion, even still more preferably one or more kinds selected from a methylammonium ion, an ethylammonium ion, a butylammonium ion and a formamidinium ion, even still more preferably a methylammonium ion.
<9>
   The light absorption layer according to <7>, wherein the R is one or more kinds selected from an alkylammonium ion and a formamidinium ion.
<10>
   The light absorption layer according to <7>, wherein the R is one or more kinds selected from a monoalkylammonium ion and a formamidinium ion.
<11>
   The light absorption layer according to <7>, wherein the R is one or more kinds selected from a methylammonium ion, an ethylammonium ion, a butylammonium ion and a formamidinium ion.
<12>
   The light absorption layer according to <7>, wherein the R is a methylammonium ion.
<13>
   The light absorption layer according to <7>, wherein R¹, R², and R³ are one or more kinds selected from a cation of a first group element of the periodic table and an organic cation, the cation of a first group element of the periodic table is preferably one or more kinds selected from Li⁺, Na⁺, K⁺, and Cs⁺, the organic cation is preferably one or more kinds selected from an ammonium ion optionally having a substituent and a phosphonium ion optionally having a substituent, and the ammonium ion optionally having a substituent is preferably one or more kinds selected from an alkylammonium ion, a formamidinium ion, and an arylammonium ion, more preferably one or more kinds selected from an alkylammonium ion and a formamidinium ion, still more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecylammonium ion, a tetradecylammonium ion, a hexadecylammonium ion, and an octadecylammonium ion.
<14>
   The light absorption layer according to <7> or <13>, wherein n is an integer of 1 or more and 4 or less.
<15>
   The light absorption layer according to any one of <7> to <14>, wherein the M is preferably one or more kinds selected from Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺ and Eu²⁺, more preferably one or more kinds selected from Pb²⁺, Sn²⁺ and Ge²⁺, still more preferably one or more kinds selected from Pb²⁺ and Sn²⁺, even still more preferably Pb²⁺.
<16>
   The light absorption layer according to any one of <7> to <14>, wherein the M is Pb²⁺, Sn²⁺, or Ge²⁺.
<17>
   The light absorption layer according to any one of <7> to <16>, wherein the X is preferably one or more kinds selected from a fluorine anion, a chlorine anion, a bromine anion and an iodine anion, more preferably one or more kinds selected from a fluorine anion, a chlorine anion and a bromine anion, still more preferably one or more kinds selected from a chlorine anion and a bromine anion, even still more preferably a bromine anion.
<18>
   The light absorption layer according to any one of <7> to <17>, wherein the X is a fluorine anion, a chlorine anion, a bromine anion, or an iodine anion.
<19>
   The light absorption layer according to any one of <1> to <18>, wherein the band gap energy of the perovskite compound is preferably 1.5 eV or more, more preferably 1.7 eV or more, still more preferably 2.0 eV or more, still more preferably 2.1 eV or more, still more preferably 2.2 eV or more, and preferably 4.0 eV or less, more preferably 3.6 eV or less, still more preferably 3.0 eV or less, still more preferably 2.4 eV or less.
<20>
   The light absorption layer according to any one of <7> to <19>, wherein the compound represented by the general formula (1) is preferably one or more kinds selected from CH₃NH₃PbBr₃ and CH(=NH)NH₃PbBr₃, and more preferably CH₃NH₃PbBr₃.
<21>
   The light absorption layer according to any one of <1>, <2> and <4> to <20>, wherein the quantum dot having an upper end of a valence band at an energy level more negative than an upper end of a valence band of the perovskite compound contains one or more kinds of elements selected from the group consisting of Si, Cu, Ge, Ag, Ga, and Al.
<22>
   The light absorption layer according to any one of <1>, <2> and <4> to <20>, wherein the quantum dot having an upper end of a valence band at an energy level more negative than an upper end of a valence band of the perovskite compound is at least one kind selected from the group consisting of Si, CuInS₂, and Ag₈SnS₆.
<23>
   The light absorption layer according to any one of <1>, <2> and <4> to <20>, wherein the quantum dot having an upper end of a valence band at an energy level more negative than an upper end of a valence band of the perovskite compound is Si, or CuInS₂.
<24>
   The light absorption layer according to any one of <2> to <20>, wherein the quantum dot made of an indirect transition type semiconductor contains one or more kinds of elements selected from the group consisting of Si, Cu, C, Ge, Ag, Ga, and Al.
<25>
   The light absorption layer according to any one of <2> to <20>, wherein the quantum dot made of an indirect transition type semiconductor is at least one kind selected from the group consisting of Si and Ag₈SnS₆.
<26>
   The light absorption layer according to any one of <2> to <20>, wherein the quantum dot made of an indirect transition type semiconductor is Si.
<27>
   The light absorption layer according to any one of <1> and <4> to <20>, wherein the quantum dot having an upper end of a valence band at an energy level more negative than an upper end of a valence band of the perovskite compound is preferably a quantum dot made of an indirect transition type semiconductor, and more preferably at least one kind selected from the group consisting of Si and Ag₈SnS₆.
<28>
   The light absorption layer according to any one of <1> to <27>, wherein a band gap energy of the quantum dot is 0.5 eV or more and equal to or less than a band gap energy of the perovskite compound.
<29>
   The light absorption layer according to any one of <1> to <28>, wherein a band gap energy of the quantum dot is preferably 0.7 eV or more, more preferably 0.8 eV or more, still more preferably 0.9 eV or more, and preferably 1.6 eV or less, more preferably 1.4 eV or less, still more preferably 1.3 eV or less.
<30>
   The light absorption layer according to any one of <1> to <29>, wherein a difference between the band gap energy of the bulk semiconductor and a band gap energy of the quantum dot is preferably 0.4 eV or more, more preferably 0.6 eV or more, still more preferably 0.7 eV or more, even still more preferably 0.8 eV or more, and preferably 2.0 eV or less, more preferably 1.5 eV or less, still more preferably 1.3 eV or less, even still more preferably 1.0 eV or less.
<31>
   The light absorption layer according to any one of <1> to <27>, wherein preferably, the band gap energy of the quantum dot is 0.7 eV or more and 1.6 eV or less, and the difference between the band gap energy of the perovskite compound and the band gap energy of the quantum dot is 0.4 eV or more and 2.0 eV or less,
   more preferably, the band gap energy of the quantum dot is 0.8 eV or more and 1.4 eV or less, and the difference between the band gap energy of the perovskite compound and the band gap energy of the quantum dot is 0.6 eV or more and 1.5 eV or less,
   still more preferably, the band gap energy of the quantum dot is 0.9 eV or more and 1.3 eV or less, and the difference between the band gap energy of the perovskite compound and the band gap energy of the quantum dot is 0.7 eV or more and 1.3 eV or less, and
   still more preferably, the band gap energy of the quantum dot is 0.9 eV or more and 1.3 eV or less, and the difference between the band gap energy of the perovskite compound and the band gap energy of the quantum dot is 0.8 eV or more and 1.0 eV or less.
<32>
   The light absorption layer according to any one of <1> to <31>, wherein an absolute value of an energy level difference between the upper end of a valence band of the perovskite compound and the upper end of a valence band of the quantum dot is 0.01 to 1.0 eV.
<33>
   The light absorption layer according to any one of <1> to <31>, wherein an absolute value of an energy level difference between the upper end of the valence band of the perovskite compound and the upper end of the valence band of the quantum dot is preferably 0.01 eV or more, more preferably 0.02 eV or more, still more preferably 0.03 eV or more, and preferably 1.0 eV or less, more preferably 0.5 eV or less, still more preferably 0.3 eV or less.
<34>
   The light absorption layer according to any one of <1> to <27>, wherein preferably, the band gap energy of the quantum dot is 0.7 eV or more and 1.6 eV or less, the difference between the band gap energy of the perovskite compound and the band gap energy of the quantum dot is 0.4 eV or more and 2.0 eV or less, and the absolute value of the energy level difference between the upper end of the valence band of the perovskite compound and the upper end of the valence band of the quantum dot is 0.01 eV or more and 1.0 eV or less,
   more preferably, the band gap energy of the quantum dot is 0.8 eV or more and 1.4 eV or less, the difference between the band gap energy of the perovskite compound and the band gap energy of the quantum dot is 0.6 eV or more and 1.5 eV or less, and the absolute value of the energy level difference between the upper end of the valence band of the perovskite compound and the upper end of the valence band of the quantum dot is 0.02 eV or more and 0.5 eV or less, and
   still more preferably, the band gap energy of the quantum dot is 0.9 eV or more and 1.3 eV or less, the difference between the band gap energy of the perovskite compound and the band gap energy of the quantum dot is 0.7 eV or more and 1.3 eV or less, and the absolute value of the energy level difference between the upper end of the valence band of the perovskite compound and the upper end of the valence band of the quantum dot is 0.03 eV or more and 0.3 eV or less, and
   still more preferably, the band gap energy of the quantum dot is 0.9 eV or more and 1.3 eV or less, the difference between the band gap energy of the perovskite compound and the band gap energy of the quantum dot is 0.8 eV or more and 1.0 eV or less, and the absolute value of the energy level difference between the upper end of the valence band of the perovskite compound and the upper end of the valence band of the quantum dot is 0.03 eV or more and 0.3 eV or less.
<35>
   The light absorption layer according to any one of <1> to <34>, wherein a particle size of the quantum dot is preferably 0.1 nm or more, more preferably 1 nm or more, still more preferably 2 nm or more, and preferably 10 nm or less, more preferably 5 nm or less, still more preferably 3 nm or less.
<36>
   The light absorption layer according to any one of <1> to <35>, wherein a preferable combination of the perovskite compound and the quantum dot is CH₃NH₃PbBr₃ and Si or CuInS₂, CH₃NH₃PbI₃ and Si or CuInS₂, or CH(=NH)NH₃PbBr₃ and Si or CuInS₂.
<37>
   The light absorption layer according to any one of <1> to <36>, wherein a content of the quantum dot in the light absorption layer is preferably 3% by volume or more, more preferably 4% by volume or more, still more preferably 5% by volume or more, and preferably 40% by volume or less, more preferably 30% by volume or less, still more preferably 25% by volume or less.
<38>
   The light absorption layer according to any one of <1> to <36>, wherein the content of the quantum dot in the light absorption layer is 3% by volume or more and 40% by volume or less.
<39>
   The light absorption layer according to any one of <1> to <36>, wherein the content of the quantum dot in the light absorption layer is 4% by volume or more and 30% by volume or less.
<40>
   The light absorption layer according to any one of <1> to <36>, wherein the content of the quantum dot in the light absorption layer is 5% by volume or more and 25% by volume or less.
<41>
   The light absorption layer according to any one of <1> to <40>, wherein a thickness of the light absorption layer is preferably 30 nm or more, more preferably 50 nm or more, still more preferably 80 nm or more, and preferably 1000 nm or less, more preferably 800 nm or less, still more preferably 600 nm or less, even still more preferably 500 nm or less.
<42>
   A coating liquid comprising: a perovskite compound or a precursor thereof; and a quantum dot having an upper end of a valence band at an energy level more negative than an upper end of a valence band of the perovskite compound.
<43>
   A coating liquid comprising: a perovskite compound or a precursor thereof; and a quantum dot made of an indirect transition type semiconductor.
<44>
   The coating liquid according to <42> or <43>, wherein the coating liquid contains a solvent.
<45>
   The coating liquid according to any one of <42> to <44>, wherein a concentration of the quantum dot in the coating liquid is 10 mg/mL or more and 300 mg/mL or less.
<46>
   A light absorption layer obtained from the coating liquid according to any one of <42> to <45>.
<47>
   A method for producing a light absorption layer containing: a perovskite compound; and a quantum dot having an upper end of a valence band at an energy level more negative than an upper end of a valence band of the perovskite compound dispersed in a matrix of the perovskite compound, and having an intermediate band, the method comprising following steps 1 and 2:
   (step 1) a step of mixing the quantum dot or a dispersion containing the quantum dot with one or more kinds of substances selected from the perovskite compound and a precursor thereof, or a solution or a mixed liquid containing the one or more kinds of substances to obtain a coating liquid; and
   (step 2) a step of obtaining a light absorption layer from the coating liquid obtained in step 1.
<48>
   A method for producing a light absorption layer containing: a perovskite compound; and a quantum dot made of an indirect transition type semiconductor dispersed in a matrix of the perovskite compound, and having an intermediate band, the method comprising following steps 1 and 2:
   (step 1) a step of mixing the quantum dot made of an indirect transition type semiconductor or a dispersion containing the quantum dot with one or more kinds of substances selected from the perovskite compound and a precursor thereof, or a solution or a mixed liquid containing the one or more kinds of substances to obtain a coating liquid; and
   (step 2) a step of obtaining a light absorption layer from the coating liquid obtained in step 1.
<49>
   The method for producing a light absorption layer according to <47> or <48>, wherein a solvent of the dispersion, the solution, the mixed liquid is preferably a polar solvent, more preferably at least one kind of solvent selected from ketones, amide-based solvents, and dimethyl sulfoxide, still more preferably an amide-based solvent, and still more preferably N,N-dimethylformamide.
<50>
   The method for producing a light absorption layer according to any one of <47> to <49>, wherein a metal concentration of the perovskite compound and/or the precursor thereof in the coating liquid is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.
<51>
   The method for producing a light absorption layer according to any one of <47> to <50>, wherein a concentration of the quantum dot in the coating liquid is preferably 10 mg/mL or more, more preferably 15 mg/mL or more, still more preferably 20 mg/mL or more, and preferably 300 mg/mL or less, more preferably 100 mg/mL or less, still more preferably 50 mg/mL or less.
<52>
   The method for producing a light absorption layer according to any one of <47> to <49>, wherein preferably, the metal concentration of the perovskite compound and/or the precursor thereof in the coating liquid is 0.1 mol/L or more and 1.5 mol/L or less, and the concentration of the quantum dot in the coating liquid is 10 mg/mL or more and 300 mg/mL or less,
   more preferably, the metal concentration of the perovskite compound and/or the precursor thereof in the coating liquid is 0.2 mol/L or more and 1.0 mol/L or less, and the concentration of the quantum dot in the coating liquid is 15 mg/mL or more and 100 mg/mL or less, and
   still more preferably, the metal concentration of the perovskite compound and/or the precursor thereof in the coating liquid is more preferably 0.3 mol/L or more and 0.5 mol/L or less, and the concentration of the quantum dot in the coating liquid is 20 mg/mL or more and 50 mg/mL or less.
<53>
   The method for producing a light absorption layer according to any one of <47> to <52>, wherein a mixing temperature at the time of preparing the coating liquid is preferably 0°C or higher, more preferably 10°C or higher, still more preferably 20°C or higher, and preferably 50°C or lower, more preferably 40°C or lower, still more preferably 30°C or lower.
<54>
   The method for producing a light absorption layer according to any one of <47> to <53>, wherein a mixing time at the time of preparing the coating liquid is preferably more than 0 hour, more preferably 0.1 hours or more, and preferably 72 hours or less, more preferably 24 hours or less, still more preferably 1 hour or less.
<55>
   The method for producing a light absorption layer according to any one of <47> to <54>, wherein the coating liquid is obtained by filtering to remove coarse particles, the pore size of the filter at the time of filtration is preferably 0.1 µm or more, more preferably 0.2 µm or more, and preferably 1 µm or less, more preferably 0.5 µm or less, and a material of the filter is preferably hydrophobic, and more preferably polytetrafluoroethylene (PTFE) .
<56>
   The method for producing a light absorption layer according to any one of <47> to <55>, wherein step 2 is preferably a wet process, more preferably a spin coating method, and a maximum rotation speed of a spin coater in the spin coating method is preferably 500 rpm or more, more preferably 1,000 rpm or more, still more preferably 2,000 rpm or more, and preferably 8,000 rpm or less, more preferably 7,000 rpm or less, still more preferably 6,000 rpm or less.
<57>
   The method for producing a light absorption layer according to any one of <47> to <56>, wherein in step 2, after the coating liquid is applied onto a substrate (functional layer), a poor solvent of the perovskite compound is applied or dropped onto the substrate, thereby improving a crystal deposition rate of the perovskite compound.
<58>
   The method for producing a light absorption layer according to <57>, wherein the poor solvent is toluene, chlorobenzene, dichloromethane, or a mixed solvent thereof.
<59>
   The method for producing a light absorption layer according to any one of <56> to <58>, wherein a drying method in the wet process is preferably thermal drying, a temperature of the thermal drying is preferably 60°C or higher, more preferably 80°C or higher, still more preferably 90°C or higher, and preferably 200°C or lower, more preferably 150°C or lower, still more preferably 120°C or lower, still more preferably 110°C or lower, and a time of the thermal drying is preferably 1 minute or more, more preferably 5 minutes or more, still more preferably 8 minutes or more, and preferably 120 minutes or less, more preferably 60 minutes or less, still more preferably 20 minutes or less, still more preferably 12 minutes or less.
<60>
   A photoelectric conversion element comprising the light absorption layer according to any one of <1> to <41>, and <46>.
<61>
   An intermediate band solar cell comprising the photoelectric conversion element according to <60>.

### EXAMPLES

Hereinafter, the present invention will be described specifically based on Examples. Unless otherwise indicated in the table, the content of each component is % by mass. In addition, the evaluation/measurement method are as follows. In addition, unless otherwise specified, the implementation/measurement was performed in an environment of 25°C and normal pressure. Note that "normal pressure" refers to 101.3 kPa.

### <I-V Curve>

Using an I-V characteristic measuring device (PECK 2400-N, manufactured by Peccell Technologies, Inc.) with a xenon-lamp white light as a light source (PEC-L01, manufactured by Peccell Technologies, Inc.) at a light intensity (100 mW/cm²) equivalent to sunlight (AM 1.5) under a mask of light irradiation area 0.0363 cm² (2 mm square), an I-V curve of the cell was measured under the conditions of a scanning speed of 0.1 V/sec (0.01 V step), a waiting time of 50 msec after voltage setting, a measurement integration time of 50 msec, a starting voltage of -0.1 V, and an ending voltage of 1.1 V. The light intensity was corrected with a silicon reference (BS-520, 0.5714 mA) . The open circuit voltage (V), the fill factor (FF), and the conversion efficiency (%) were determined from the I-V curve.

### <Valence band level>

The valence band levels of the perovskite compound and the quantum dot were measured and calculated using an ionization energy measuring apparatus (BIP-KV100, manufactured by JASCO Corporation). In the case of the perovskite compound, a sample in which a film is formed on a glass substrate was used, and in the case of the quantum dot, a powder sample was used.

### <Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a FTO (fluorine-doped tin oxide) substrate (manufactured by Asahi Glass Fabritec Co., Ltd., 25 × 25 × 1.8 mm).

The absorption spectrum of the dispersion of the CuInS₂ quantum dot in which sodium sulfide was coordinated was similarly measured with a 1 cm square quartz cell in a dispersion having a concentration of 0.1 mg/mL or more and 1 mg/mL or less of the CuInS₂ quantum dot in which sodium sulfide was coordinated.

The absorption spectrum of the dispersion of the PbS quantum dot in which iodine was coordinated was similarly measured with a 1 cm square quartz cell in a dispersion having a concentration of 0.1 mg/mL or more and 1 mg/mL or less of the PbS quantum dot in which iodine was coordinated. As a dispersion solvent, N,N-dimethylformamide (DMF) was used.

Note that the absorption spectrum of the horizontal axis representing the wavelength λ and the vertical axis representing the absorbance A was converted into the spectrum of the horizontal axis representing the energy hν and the vertical axis representing (αhν)^{1/2} (α; absorption coefficient), and a straight line was fitted to the rising part of absorption and the intersection of the straight line and the baseline was taken as the band gap energy.

The band gap energy of the Si quantum dot (manufactured by Quantum14, Ltd) used was 1.6 eV as a manufacturer's nominal value.

### <Particle size of quantum dot>

A slurry prepared by dispersing CuInS₂ quantum dots in which sodium sulfide was coordinated in hexane was dropped onto a carbon film (Ultra High Resolution Carbon UHR-C10 STEM Cu 100 P, grid specification, manufactured by Okenshoji Co., Ltd.), and dried at room temperature to obtain an observation sample. The observation sample was observed with a transmission electron microscope (JEM-2100, manufactured by JEOL Ltd.) at an acceleration voltage of 120 kV and a magnification of 300,000 times, and a TEM (transmission electron microscope) image of the sample was obtained. Next, the particle sizes of respective particles in the image were determined from the obtained image using image analysis software (Imaga J, manufactured by the National Institute of Health). The particle size of the CuInS₂ quantum dot in which sodium sulfide was coordinated was calculated through calculation of the average value of the particle sizes of the obtained quantum dots, and the average particle size was 2.4 nm.

The particle size of the used Si quantum dot (manufactured by Quantum14, Ltd) is 3 nm or less in a manufacturer's nominal value.

### <Example 1>

The following steps (1) to (7) were carried out sequentially to prepare a cell.

### (1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

### (2) Ozone Cleaning

Ozone cleaning of the FTO substrate was performed immediately before the compact TiO₂ layer forming step. With the FTO side facing up, the substrate was placed in an ozone generator (ozone cleaner PC-450 UV, manufactured by Meiwafosis Co., Ltd.) and irradiated with UV for 30 minutes.

### (3) Formation of Compact TiO₂ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (anhydrous, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by FUJIFILM Wako Pure Chemical Corporation) and heated at 70°C for 30 minutes. After washing with water and drying, the FTO substrate was calcined at 500°C for 20 minutes (temperature rising: 15 minutes) to form a compact TiO₂ (cTiO₂) layer.

### (4) Formation of Mesoporous TiO₂ Layer (Porous Layer)

Ethanol (1.41 g, anhydrous, manufactured by FUJIFILM Wako Pure Chemical Corporation) was added to 0.404 g of an anatase form TiO₂ paste (PST-18NR, manufactured by JGC Catalysts and Chemicals Ltd.) and the mixture was subjected to ultrasonic dispersion for 1 hour to obtain a TiO₂ coating liquid. In a dry room, the TiO₂ coating liquid was spin-coated (5000 rpm × 30 sec) on the cTiO₂ layer using a spin coater (MS-100, manufactured by Mikasa Co., Ltd.). After drying for 30 minutes on a hot plate at 125°C, the cTiO₂ layer was calcined at 500°C for 30 minutes (time for temperature rising: 60 minutes) to form a mesoporous TiO₂ (mTiO₂) layer.

### (5) Formation of light absorption layer

The light absorption layer and the hole transport layer were formed in a glove box at 25°C. Lead bromide (0.228 g, PbBr₂, for perovskite precursor, manufactured by Tokyo Chemical Industry Co., Ltd.), 0.070 g of methylamine hydrobromide (CH₃NH₃Br, manufactured by Tokyo Chemical Industry Co., Ltd.), and 2 mL of a DMF dispersion of Si quantum dots (concentration: 25 mg/mL, Quantum14, Ltd) were mixed and stirred at room temperature to prepare a DMF solution (colorless and transparent) of a 0.31 mol/L perovskite (CH₃NH₃PbBr₃) raw material in which Si quantum dots were dispersed. The mixture was stirred for dispersion for 15 minutes, and then filtered through a PTFE filter having a pore size of 0.45 µm to obtain a coating liquid containing Si quantum dots and a perovskite raw material.

The mTiO₂ layer was spin-coated with the coating liquid by a spin coater (MS-100, manufactured by Mikasa Co., Ltd.) (5,000 rpm × 30 sec). After 5 seconds from the start of spinning, 1 mL of toluene (anhydrous, manufactured by FUJIFILM Wako Pure Chemical Corporation) as a poor solvent was dropped at once onto the center of the spin. Immediately after spin coating, the coated product was dried on a 100°C hot plate for 10 minutes to form a light absorption layer. The light absorption layer contains a perovskite compound (CH₃NH₃PbBr₃) and a Si quantum dot. Formation of the perovskite compound was confirmed by X-ray diffraction pattern, absorption spectrum, and electron microscope observation, and presence of the Si quantum dot was also confirmed from fluorescence spectrum and electron microscope observation.

### (6) Formation of Hole Transport Layer

Bis(trifluoromethanesulfonyl)imide lithium (LiTFSI, 9.1 mg, manufactured by FUJIFILM Wako Pure Chemical Corporation), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by FUJIFILM Wako Pure Chemical Corporation.), 72.3 mg of 2,2',7,7'-tetrakis[N,N-di-p-methoxyphenylamino]-9,9'-spirobifluorene (Spiro-OMeTAD, manufactured by FUJIFILM Wako Pure Chemical Corporation.), 1 mL of chlorobenzene (manufactured by Nacalai Tesque), and 28.8 µL of tributylphosphine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 µm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO and the entire back surface of the substrate was wiped off with a cotton swab impregnated with γ-butyrolactone (manufactured by FUJIFILM Wako Pure Chemical Corporation.), further drying was performed on a hot plate at 70°C for several minutes, thereby forming a hole transport layer.

### (7) Deposition of Gold Electrode

Gold was deposited to a thickness of 100 nm on the hole transport layer (vacuum deposition rate: 8 to 9 Å/sec) under vacuum (4 to 5 × 10⁻³ Pa) using a vacuum vapor deposition apparatus (VTR-060M/ERH, manufactured by ULVAC KIKO Inc.) to form a gold electrode.

### Example 2

### <Synthesis of CuInS₂ quantum dot in which 1-dodecanethiol was coordinated>

Copper iodide (47.5 mg, manufactured by Sigma-Aldrich Japan K.K.), 292 mg of indium acetate (manufactured by Alfa Aesar), and 10 mL of 1-dodecanethiol (manufactured by Sigma-Aldrich Japan K.K.) were charged into a 100 mL three-necked flask, and the inside of the reaction system was purged with nitrogen. After stirring at 100°C for 5 minutes under a nitrogen atmosphere, the temperature was maintained at 230°C for 10 minutes to produce CuInS₂ quantum dots in which 1-dodecanethiol was coordinated. After cooling, acetone was added, and the supernatant was removed by centrifugation (CN-2060, manufactured by Hsiangtai Machinery Industry Co., Ltd., 5,000 rpm, 5 minutes), and the precipitate was collected to obtain a CuInS₂ quantum dot solid in which 1-dodecanethiol was coordinated.

### <Synthesis of CuInS₂ quantum dot in which sodium sulfide was coordinated>

The CuInS₂ quantum dot solid in which 1-dodecanethiol was coordinated (0.270 g) was added and dispersed in 54 mL of toluene bubbled with nitrogen (anhydrous, manufactured by FUJIFILM Wako Pure Chemical Corporation) to obtain a red CuInS₂ toluene dispersion. On the other hand, sodium sulfide (0.300 g, manufactured by FUJIFILM Wako Pure Chemical Corporation) was dissolved in 60 mL of formamide bubbled with nitrogen (manufactured by FUJIFILM Wako Pure Chemical Corporation) to obtain a sodium sulfide solution. The CuInS₂ toluene dispersion and the sodium sulfide solution were mixed and stirred at room temperature under a nitrogen atmosphere. After one day, it was confirmed that CuInS₂ quantum dots were dispersed in the formamide phase, and the formamide phase was collected. Acetone was added to the collected formamide solution, the supernatant was removed by centrifugation (CN-2060, manufactured by Hsiangtai Machinery Industry Co., Ltd., 5,000 rpm, 5 minutes), and the precipitate was collected to obtain a CuInS₂ quantum dot solid in which sodium sulfide was coordinated.

A light absorption layer was formed in the same manner as in Example 1 except for using 2 mL of a DMF dispersion (concentration: 23 mg/mL) containing a CuInS₂ quantum dot solid in which sodium sulfide was coordinated in place of 2 mL of a DMF dispersion (concentration: 25 mg/mL) of Si quantum dots in Example 1, and a cell was produced.

### Comparative Example 1

### <Synthesis of PbS quantum dot in which oleic acid was coordinated>

Lead oxide (0.45 g, manufactured by FUJIFILM Wako Pure Chemical Corporation), 10 g of octadecene (manufactured by Sigma-Aldrich Japan K.K.), and 1.34 g of oleic acid (manufactured by Sigma-Aldrich Japan K.K.) were charged into a 50 mL three-necked flask, and the mixture was stirred at 80°C for 2 hours to prepare a Pb source solution. The inside of the reaction system was evacuated by a vacuum pump, nitrogen gas was introduced to return the pressure to atmospheric pressure, and then the mixture was further stirred at 110°C for 30 minutes. On the other hand, 210 pL of 1,1,1,3,3,3-hexamethyldisilathiane (manufactured by Tokyo Chemical Industry Co., Ltd.) was dissolved in 4 mL of octadecene to prepare an S source solution. Under stirring and nitrogen gas atmosphere at 110°C, the S source solution was injected into the Pb source solution at once using a syringe to produce PbS quantum dots in which oleic acid was coordinated. A large excess of acetone was added to stop the reaction, then the supernatant was removed by centrifugation (CR21 GIII, R15A rotor, manufactured by Hitachi Koki Co., Ltd., 2,500 rpm, 2 minutes), and the precipitate was dried under reduced pressure to obtain a PbS quantum dot solid in which oleic acid was coordinated.

Regarding concentration of each component in the PbS quantum dot solid in which oleic acid was coordinated, the Pb concentration was 66% by mass, the oleic acid concentration was 22% by mass, and the ratio of oleic acid/Pb (molar ratio) was 0.25. The X-ray diffraction result showed that the crystallite diameter was 2.7 nm, and the absorption spectrum showed that the absorption edge wavelength was 1,070 nm and the absorption peak wavelength was 970 nm (the peak absorbance of a hexane dispersion having a solid content concentration of 1 mg/mL was 0.501).

### <Synthesis of PbS quantum dot in which Iodine was coordinated>

A PbS quantum dot solid in which oleic acid was coordinated (0.20 g) was dispersed in 2 mL of toluene (anhydrous, manufactured by FUJIFILM Wako Pure Chemical Corporation) to obtain a black transparent dispersion. On the other hand, 0.053 g of methylamine hydroiodide (CH₃NH₃I, manufactured by Tokyo Chemical Industry Co., Ltd.) was dissolved in 0.5 mL of DMF (anhydrous, manufactured by FUJIFILM Wako Pure Chemical Corporation) and 1 mL of toluene (anhydrous, manufactured by FUJIFILM Wako Pure Chemical Corporation) (molar ratio of CH₃NH₃I to oleic acid was 2). The CH₃NH₃I solution was added dropwise to the PbS quantum dot dispersion at a dropping rate of 1 drop/10 sec (dropping time: 11 minutes) at room temperature (25°C) under a nitrogen atmosphere (in a glove box) without stirring, and then the mixture was allowed to stand for 18 hours. Further, 5 mL of methanol was added, and after mixing, the mixture was filtered through a filter (pore size: 0.2 µm, material: PTFE) and dried to obtain a PbS quantum dot solid in which iodine was coordinated.

A light absorption layer was formed in the same manner as in Example 1 except for using 2 mL of a DMF dispersion (concentration: 100 mg/mL) containing a PbS quantum dot solid in which iodine was coordinated in place of 2 mL of a DMF dispersion (concentration: 25 mg/mL) of Si quantum dots in Example 1, and a cell was produced.

**[Table 1]**

| | | | Example 1 | Example 2 | Comparative Example 1 |
|---|---|---|---|---|---|
| Perovskite (P) | Compound | | CH₃NH₃PbBr₃ | CH₃NH₃PbBr₃ | CH₃NH₃PbBr₃ |
| | Band gap energy | (eV) | 2.3 | 2.3 | 2.3 |
| | Energy level at upper end of valence band | (eV) | -5.6 | -5.6 | -5.6 |
| Quantum dot (QD) | Compound | | Si | CuInS₂ | PbS |
| | Transition type | | Indirect transition | Direct transition | Direct transition |
| | Energy level at upper end of valence band | (eV) | -5.66 | -5.64 | -5.17 |
| | Band gap energy | (eV) | 1.6 | 1.48 | 1.2 |
| | Blending amount | (% by volume) | 17 | 5 | 12 |
| Cell property | Conversion efficiency | (%) | 0.83 | 0.69 | 0.38 |
| | Open circuit voltage | (V) | 0.73 | 0.79 | 0.36 |
| | Fill factor | | 0.55 | 0.61 | 0.44 |

### INDUSTRIAL APPLICABILITY

The light absorption layer and photoelectric conversion element of the present invention can be suitably used as constituent members of an intermediate band solar cell.

### DESCRIPTION OF REFERENCE SIGNS

- 1: Photoelectric conversion element
- 2: Transparent substrate
- 3: Transparent conductive layer
- 4: Blocking layer
- 5: Porous layer
- 6: Light absorption layer
- 7: Hole transport layer
- 8: Electrode (positive electrode)
- 9: Electrode (negative electrode)
- 10: Light

## Claims

1. A light absorption layer comprising: a perovskite compound; and a quantum dot having an upper end of a valence band at an energy level more negative than an upper end of a valence band of the perovskite compound, the light absorption layer having an intermediate band.

2. The light absorption layer according to claim 1, wherein the quantum dot is an indirect transition type semiconductor.

3. The light absorption layer according to claim 1 or 2, wherein the quantum dot having an upper end of a valence band at an energy level more negative than an upper end of a valence band of the perovskite compound contains one or more kinds of elements selected from the group consisting of Si, Cu, Ge, Ag, Ga, and Al.

4. The light absorption layer according to claim 1 or 2, wherein the quantum dot having an upper end of a valence band at an energy level more negative than an upper end of a valence band of the perovskite compound is at least one kind selected from the group consisting of Si, CuInS₂, and Ag₈SnS₆.

5. A light absorption layer comprising: a perovskite compound; and a quantum dot made of an indirect transition type semiconductor, the light absorption layer having an intermediate band.

6. The light absorption layer according to claim 5, wherein the quantum dot made of an indirect transition type semiconductor contains one or more kinds of elements selected from the group consisting of Si, Cu, C, Ge, Ag, Ga, and Al.

7. The light absorption layer according to claim 5, wherein the quantum dot made of an indirect transition type semiconductor is at least one kind selected from the group consisting of Si and Ag₈SnS₆.

8. The light absorption layer according to any one of claims 1 to 7, wherein an absolute value of an energy level difference between the upper end of a valence band of the perovskite compound and the upper end of a valence band of the quantum dot is 0.01 to 1.0 eV.

9. The light absorption layer according to any one of claims 1 to 8, wherein a band gap energy of the quantum dot is 0.5 eV or more and equal to or less than a band gap energy of the perovskite compound.

10. The light absorption layer according to any one of claims 1 to 9, wherein a particle size of the quantum dot is 10 nm or less.

11. The light absorption layer according to any one of claims 1 to 10, wherein the perovskite compound is one or more kinds selected from a compound represented by general formula (1) below and a compound represented by general formula (2) below:
RMX₃ (1)
wherein R is a monovalent cation, M is a divalent metal cation, and X is a halogen anion, and
R¹R²R³ₙ₋₁MₙX₃ₙ₊₁ (2)
wherein R¹, R², and R³ are each independently a monovalent cation, M is a divalent metal cation, X is a halogen anion, and n is an integer of 1 or more and 10 or less.

12. The light absorption layer according to claim 11, wherein the X is a fluorine anion, a chlorine anion, a bromine anion, or an iodine anion.

13. The light absorption layer according to claim 11 or 12, wherein the R is one or more kinds selected from an alkylammonium ion and a formamidinium ion.

14. The light absorption layer according to any one of claims 11 to 13, wherein the R¹, R², and R³ are one or more kinds selected from an alkylammonium ion and a formamidinium ion.

15. The light absorption layer according to any one of claims 11 to 14, wherein the M is Pb²⁺, Sn²⁺, or Ge²⁺.

16. The light absorption layer according to any one of claims 1 to 15, wherein a content of the quantum dot is 3% by volume or more.

17. The light absorption layer according to any one of claims 1 to 16, wherein the band gap energy of the perovskite compound is 1.5 eV or more and 4.0 eV or less.

18. A coating liquid comprising: a perovskite compound or a precursor thereof; and a quantum dot having an upper end of a valence band at an energy level more negative than an upper end of a valence band of the perovskite compound.

19. A coating liquid comprising: a perovskite compound or a precursor thereof; and a quantum dot made of an indirect transition type semiconductor.

20. The coating liquid according to claim 18 or 19, wherein the coating liquid contains a solvent.

21. The coating liquid according to any one of claims 18 to 20, wherein a concentration of the quantum dot in the coating liquid is 10 mg/mL or more and 300 mg/mL or less.

22. A light absorption layer obtained from the coating liquid according to any one of claims 18 to 21.

23. A method for producing a light absorption layer containing: a perovskite compound; and a quantum dot having an upper end of a valence band at an energy level more negative than an upper end of a valence band of the perovskite compound dispersed in a matrix of the perovskite compound, and having an intermediate band, the method comprising following steps 1 and 2:
(step 1) a step of mixing the quantum dot or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

24. A method for producing a light absorption layer containing: a perovskite compound; and a quantum dot made of an indirect transition type semiconductor dispersed in a matrix of the perovskite compound, and having an intermediate band, the method comprising following steps 1 and 2:
(step 1) a step of mixing the quantum dot made of an indirect transition type semiconductor or a dispersion containing the quantum dot with one or more kinds of substances selected from the perovskite compound and a precursor thereof, or a solution or a mixed liquid containing the one or more kinds of substances to obtain a coating liquid; and
(step 2) a step of obtaining a light absorption layer from the coating liquid obtained in step 1.

25. A photoelectric conversion element comprising the light absorption layer according to any one of claims 1 to 17, and 22.

26. An intermediate band solar cell comprising the photoelectric conversion element according to claim 25.
